(19) Europäisches Patentamt
European Patent Office
Office européen des brevets

(11) **EP 1 921 506 A2**

(12) **EUROPEAN PATENT APPLICATION**

(43) Date of publication:
**14.05.2008 Bulletin 2008/20**

(51) Int Cl.:
***G03F 9/00*** (2006.01)

(21) Application number: **07119916.0**

(22) Date of filing: **02.11.2007**

(84) Designated Contracting States:
**AT BE BG CH CY CZ DE DK EE ES FI FR GB GR
HU IE IS IT LI LT LU LV MC MT NL PL PT RO SE
SI SK TR**
Designated Extension States:
**AL BA HR MK RS**

(30) Priority: **09.11.2006 JP 2006304298**

(71) Applicant: **Dainippon Screen Mfg., Co., Ltd.
Kyoto-shi, Kyoto 602-8285 (JP)**

(72) Inventor: **Inoue, Masao
Horikawa-dori, Kamigyo-ku,Kyoto-shi Kyoto
602-8585 (JP)**

(74) Representative: **Wilhelms . Kilian & Partner
Patentanwälte
Eduard-Schmid-Strasse 2
81541 München (DE)**

(54) **Position Detecting Method and Device, Patterning Device, and Subject to be detected**

(57) A substrate to be processed by a patterning device has a group of a plurality of alignment marks formed within a predetermined area as an alignment area, each of the plurality of alignment marks being an information recording code that records its own location relative to a reference position on the substrate. In alignment of the substrate, an image of such an alignment area that includes a group of the plurality of alignment marks is captured. Thus, even if the area of image capturing is reduced with increasing image magnification, at least one of the plurality of alignment marks can be included in the image. One of the alignment marks whose images are included in this image is defined as a target mark, and the position of the substrate is derived based on the target mark in the image. Thus, the position of the substrate can be detected by a single image capturing operation.

F I G . 9

**Description**

BACKGROUND OF THE INVENTION

Field of the Invention

The present invention relates to a technique for detecting the position of a subject to be detected which is located in a predetermined configuration area.

Description of the Background Art

In patterning devices for patterning fine patterns on substrates such as color filter substrates provided with liquid crystal displays or such as flat panel display (FPD) glass substrates, semiconductor substrates, and printed circuit boards for liquid crystal displays or plasma displays, alignment for aligning a substrate to be processed precisely to a predetermined ideal position is necessary to achieve high-precision processing. There have conventionally been various proposed techniques for detecting the position of a substrate which is placed within a predetermined configuration area.
For example, a typical conventional technique is to provide an alignment mark in advance in a predetermined position on a substrate and to capture an image of the vicinity of this alignment mark with a camera. Then, based on the position of an image of the alignment mark in the image, the amount of misalignment between the actual position and the ideal position of the substrate is detected. The position of the substrate is adjusted to its ideal position based on the detected amount of misalignment, whereby the alignment of the substrate is achieved.
Now, for implementation of high-precision substrate alignment, it is necessary to capture an image of an alignment mark at a relatively high image magnification. However, increasing the image magnification considerably reduces the area of image capturing on a substrate, so in some cases, no alignment mark will be included within the area of image capturing. Hence, in the conventional techniques, low-precision prealignment (alignment at a coarse level) at a relatively low image magnification is performed prior to fine alignment at a relatively high image magnification so that, in the fine alignment, the area of image capturing includes an alignment mark.
However, such two alignment processes (two image capturing processes at high and low magnifications), prealignment and fine alignment, increase time for processing substrates and reduce throughput, so there have been requests for remedial measures.

SUMMARY OF THE INVENTION

The present invention is directed to a position detecting method for detecting a position of a subject to be detected which is located within a predetermined configuration area.
According to the present invention, the position detecting method comprises: an image capturing step of capturing an image of the subject to be detected which has formed therein a group of a plurality of position detection marks, each of the position detection marks allowing determination of a first location which is its own location relative to a reference position on the subj ect to be detected; and a position deriving step of, based on an image of one position detection mark in the image out of those of the plurality of position detection marks whose images are included in the image, determining the first location of the one position detection mark and deriving the position of the subject to be detected based on the first location.
Thus, the position of a subject to be detected can be detected by a single image capturing operation.
Preferably, the position deriving step includes: a first locating step of determining the first location of the one position detection mark; a second locating step of, based on the location of an image of the one position detection mark in the image, determining a second location which is a location of the one position detection mark relative to an image capturing device for capturing the image; and a third locating step of determining the position of the subject to be detected, based on the first location and the second location.
Thus, the position of a subject to be detected can be detected with high precision.
The present invention is also directed to a position detecting device for detecting a position of a subject to be detected which is located within a predetermined configuration area.
According to the present invention, the position detecting device comprises: an image capturing unit for capturing an image of the subject to be detected which has formed therein a group of a plurality of position detection marks, each of the position detection marks allowing determination of a first location which is its own location relative to a reference position on the subject to be detected; and a position deriving unit for, based on an image of one position detection mark in the image out of those of the plurality of position detection marks whose images are included in the image, determining the first location of the one position detection mark and deriving the position of the subject to be detected based on the first location.

Thus, the position of a subject to be detected can be detected by a single image capturing operation.

The present invention is also directed to a subject to be detected whose position is to be detected by a position detecting device.

According to the present invention, the subject to be detected comprises: a main body; and a plurality of position detection marks which are formed in a group in the main body and each of which allows determination of its own location relative to a reference position on the main body.

Thus, the position detecting device can detect the position of the subject to be detected by a single image capturing operation.

Accordingly, the object of the present invention is to provide a technique for detecting the position of a subject to be detected by a single image capturing operation.

These and other objects, features, aspects and advantages of the present invention will become more apparent from the following detailed description of the present invention when taken in conjunction with the accompanying drawings.

BRIEF DESCRIPTION OF THE DRAWINGS

Fig. 1 is a side view showing the structure of a patterning device;
Fig. 2 is a top view showing the structure of the patterning device;
Fig. 3 is a block diagram schematically showing the structure of the patterning device;
Fig. 4 is a flowchart showing a basic operation of the patterning device;
Figs. 5 to 8 show the states of a substrate during the process of patterning operation;
Fig. 9 shows a substrate whose position is to be detected;
Fig. 10 illustrates the structure of an alignment mark;
Fig. 11 shows the contents of information recorded in each alignment mark according to a first preferred embodiment;
Fig. 12 is a flowchart showing a detail of processing for substrate alignment;
Fig. 13 shows an example of an image obtained by image capturing;
Fig. 14 shows the contents of information recorded in each alignment mark according to a second preferred embodiment;
Fig. 15 shows an example of a correspondence table; and
Fig. 16 shows the inside of an aperture portion.

DESCRIPTION OF THE PREFERRED EMBODIMENTS

Hereinbelow, preferred embodiments of the present invention will be described with reference to the drawings.

<1. First Preferred Embodiment>

<1-1. Structure>

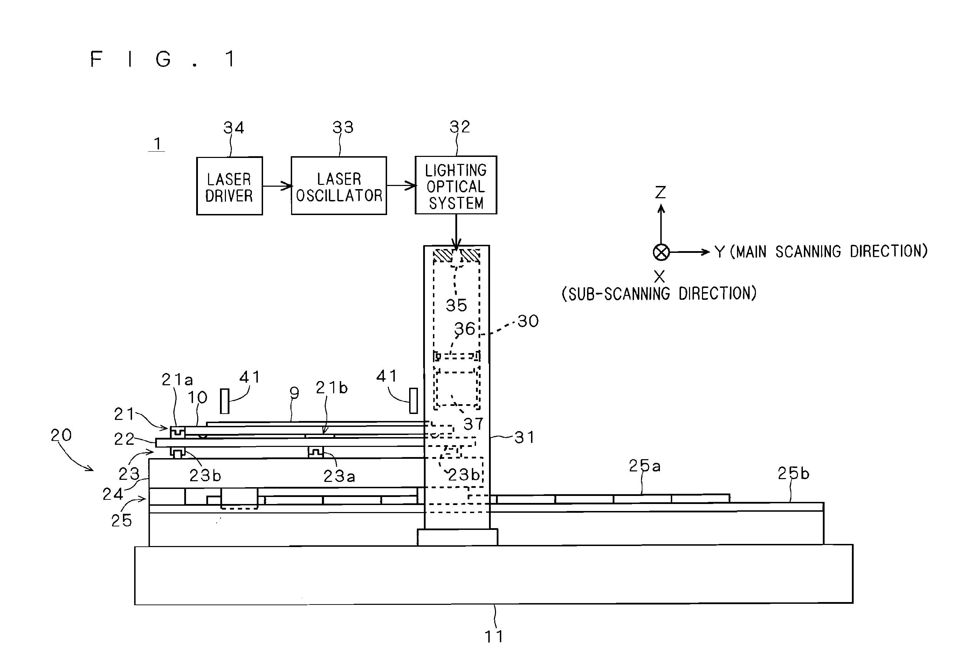

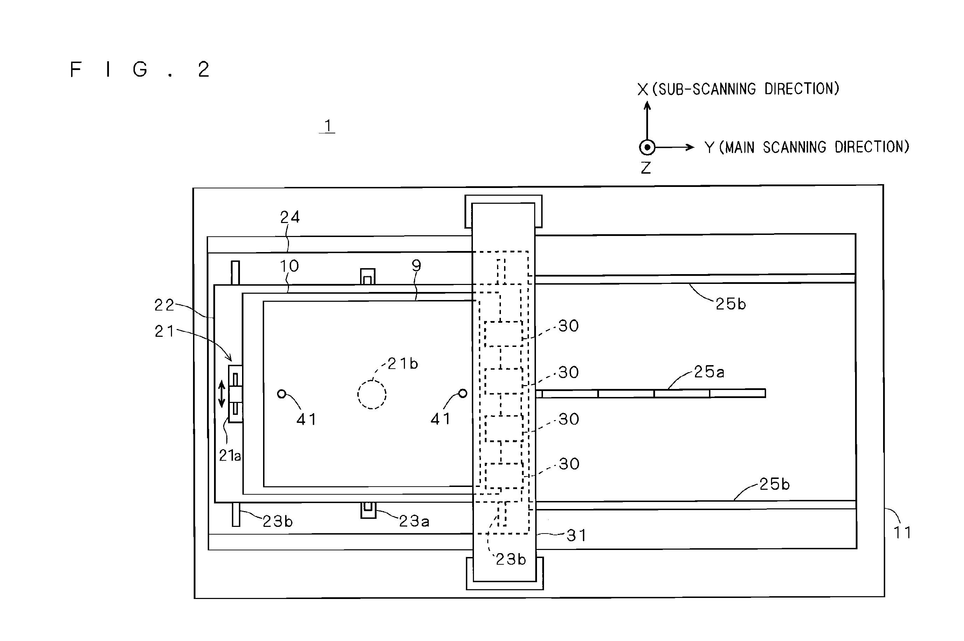

Figs. 1 and 2 are side and top views respectively of the structure of a patterning device 1 having the function of a position detecting device according to a first preferred embodiment. This patterning device 1 is a device for patterning a predetermined pattern on a color filter glass substrate (hereinafter simply referred to as a "substrate") 9 having coated thereon a photosensitive material (in this preferred embodiment, color resist) during the process of manufacturing a color filter for liquid crystal displays. As shown in Figs. 1 and 2, the patterning device 1 mainly comprises a base 11, a stage 10 on which the substrate 9 is placed, a driving unit 20 driving the stage 10 with respect to the base 11, a plurality of exposure heads 30, and two cameras 41 for alignment of the substrate 9.

In the following description, a three-dimensional XYZ rectangular coordinate system shown in the drawing is used as appropriate to indicate directions and orientations. These X-, Y-, and Z-axes are fixed relatively to the base 11. In the present example, the X- and Y-axis directions are horizontal and the Z-axis direction is vertical. A main scanning direction of the patterning device 1 corresponds to the Y-axis direction, and a sub-scanning direction thereof corresponds to the X-axis direction.

The stage 10 is flat plate-like in external shape and has on its upper surface a generally horizontal area which is a configuration area where the substrate 9 is located. Specifically, the substrate 9 is placed in a generally horizontal position on the upper surface of the stage 10. The stage 10 has formed on its upper surface a plurality of vacuum holes (not shown). The suction pressure of these vacuum holes causes the substrate 9 placed on the stage 10 to be fixedly held on the upper surface of the stage 10. Thus, the stage 10 also functions as a holder for holding the substrate 9.

The driving unit 20 is a driving mechanism for moving the stage 10 with respect to the base 11 in the main scanning direction (Y-axis direction), in the sub-scanning direction (X-axis direction), and in the direction of rotation (about the Z axis). The driving unit 20 includes a rotating mechanism 21 for rotating the stage 10, a support plate 22 supporting the underside of the stage 10, a sub-scanning mechanism 23 for moving the support plate 22 in the sub-scanning direction, and a base plate 24 supporting the support plate 22 with the sub-scanning mechanism 23 sandwiched in between, and a main scanning mechanism 25 for moving the base plate 24 in the main scanning direction.

The rotating mechanism 21 has a linear motor 21 a composed of a moving element mounted on the -Y-side end of the stage 10 and a stator laid on the upper surface of the support plate 22. The rotating mechanism 21 also has a rotation axis 21b provided between the underside of the center of the stage 10 and the support plate 22. Thus, actuating the linear motor 21 a causes the moving element to move in the X-axis direction along the stator and thereby causes the stage 10 to rotate about the rotation axis 21 b on the support plate 22 within a predetermined angle range.

The sub-scanning mechanism 23 has a linear motor 23a composed of a moving element mounted on the underside of the support plate 22 and a stator laid on the upper surface of the base plate 24. The sub-scanning mechanism 23 also has a pair of guides 23b which are provided between the support plate 22 and the base plate 24 and which extend in the sub-scanning direction. Thus, actuating the linear motor 23a causes the support plate 22 to move in the sub-scanning direction along the guides 23b on the base plate 24. Since the stage 10 is supported by the support plate 22, the sub-scanning mechanism 23, as a result, moves the stage 10 in the sub-scanning direction with respect to the base 11.

The main scanning mechanism 25 has a linear motor 25a composed of a moving element mounted on the underside of the base plate 24 and a stator laid on the base 11. The main scanning mechanism 25 also has a pair of guides 25b which are provided between the base plate 24 and the base 11 and which extend in the main scanning direction. Thus, actuating the linear motor 25a causes the base plate 24 to move in the main scanning direction along the guides 25b on the base 11. Since the stage 10 is supported by the support plate 22 and the base plate 24, the main scanning mechanism 25, as a result, moves the stage 10 in the main scanning direction with respect to the base 11.

The plurality of exposure heads 30 emit pulse light onto the upper surface of the substrate 9 placed on the stage 10 to expose the substrate 9 and thereby to pattern regular patterns. The base 11 has fixedly provided thereon a bridge-structured frame 31 which runs between the -X- and +X-side ends of the base 11 along the sub-scanning direction and which straddles the stage 10 and the driving unit 20. The plurality of exposure heads 30 are mounted on this frame 31 and arranged with the same pitch along the sub-scanning direction. Accordingly, the plurality of exposure heads 30 are fixedly located with respect to the base 11.

As previously described, the main scanning mechanism 25 and the sub-scanning mechanism 23 of the driving unit 20 move the stage 10 with respect to the base 11. Thus, driving the main scanning mechanism 25 causes the plurality of exposure heads 30 to move in the main scanning direction relatively to the substrate 9 placed on the stage 10, while driving the sub-scanning mechanism 23 causes the plurality of exposure heads 30 to move in the sub-scanning direction relatively to the substrate 9 placed on the stage 10.

Each of the exposure heads 30 is connected via a lighting optical system 32 to a single laser oscillator 33 which is a light source emitting pulse light and which is further connected to a laser driver 34. Thus, actuating the laser driver 34 causes the laser oscillator 33 to oscillate pulse light, which pulse light is then introduced into each of the exposure heads 30 through the lighting optical system 32.

Each of the exposure heads 30 has provided therein a light exit 35 from which pulse light introduced through the lighting optical system 32 exits downward, an aperture portion 36 which partially shields pulse light to form light beams of a predetermined shape, and a projection optical system 37 which projects the light beams to the upper surface of the substrate 9.

The pulse light exiting from the light exit 35 is partially shielded by a mask (not shown) with a plurality of slots when passing through the aperture portion 36, and is formed into light beams of a predetermined shape to enter the projection optical system 37. Then, the pulse light of the predetermined shape passing through the projection optical system 37 is emitted on the upper surface of the substrate 9, whereby the photosensitive material coated on the substrate 9 is exposed to the light and patterns are formed on the substrate 9. The mask is formed of a number of slots which are openings passing light and which are arranged at regular intervals along the sub-scanning direction. Passing through these slots, pulse light formed into a shape corresponding to the shapes of the slots is projected onto the substrate 9. The aperture portion 36 is provided with a moving mechanism for moving the position of the mask minutely inside the aperture portion 36, which allows fine adjustments of the position where patterns are formed on the substrate 9.

The two cameras 41 each are an image capturing part which is located above the stage 10 for capturing an image of the substrate 9 placed on the stage 10 and which includes an optical system and an image capturing element such as CCD. Images obtained with these cameras 41 are used for aligning the substrate 9 placed on the stage 10 to a predetermined ideal position. The cameras 41 are fixed relatively to the base 11 via a holder (not shown) with optical axes of their optical systems directed vertically downward (toward the -Z-side).

The two cameras 41 are located in the same positions with respect to the sub-scanning direction, and during alignment, they are located almost in the middle of the sides of the substrate 9 along the sub-scanning direction (in the state shown in Fig. 2). Also, during alignment, one of the cameras 41 is located in the vicinity of the -Y-side end of the substrate 9, and the other cameras 41 is located in the vicinity of the +Y-side end of the substrate 9.

The patterning device 1 comprises a controller 50 for controlling the whole device and performing various computations. Fig. 3 is a block diagram schematically showing the structure of the patterning device 1 including the controller 50. The controller 50 is comprised of a computer including a CPU, a memory, and the like.

As shown, the main scanning mechanism 25, the sub-scanning mechanism 23, the rotating mechanism 21, the laser driver 34, the cameras 41, and the like, which have been described above, are electrically connected to the controller 50. Thus, they operate under control of the controller 50, and images obtained with the cameras 41 are inputted into the controller 50 and stored in the memory in the controller 50.

The patterning device 1 further comprises an operation unit 12 accepting various kinds of users' operations, and a data input unit 13 inputting patterning data necessary for patterning. The data input unit 13 composes, for example, a reader reading a recording medium, a communication device performing data communication between external devices, or the like. The operation unit 12 and the data input unit 13 described herein are also electrically connected to the controller 50. Thus, the contents of operations of the operation unit 12 are inputted as signals into the controller 50, and patterning data entered in the data input unit 13 is stored in the memory in the controller 50.

The controller 50 achieves the function of controlling each part of the device and various computation functions by the CPU performing computations according to a program previously stored in the memory. Referring to Fig. 3, a position deriving unit 51 and a position adjustment unit 52 schematically show the functions achieved using software executed by the CPU performing computations according to a program. First, second, and third locators 53, 54, and 55 schematically show the functions of the position deriving unit 51. The position deriving unit 51 and the position adjustment unit 52 described herein carry out part of the function of aligning the substrate 9, specifically, detecting and adjusting the position of the substrate 9.

<1-2. Basic Operation>

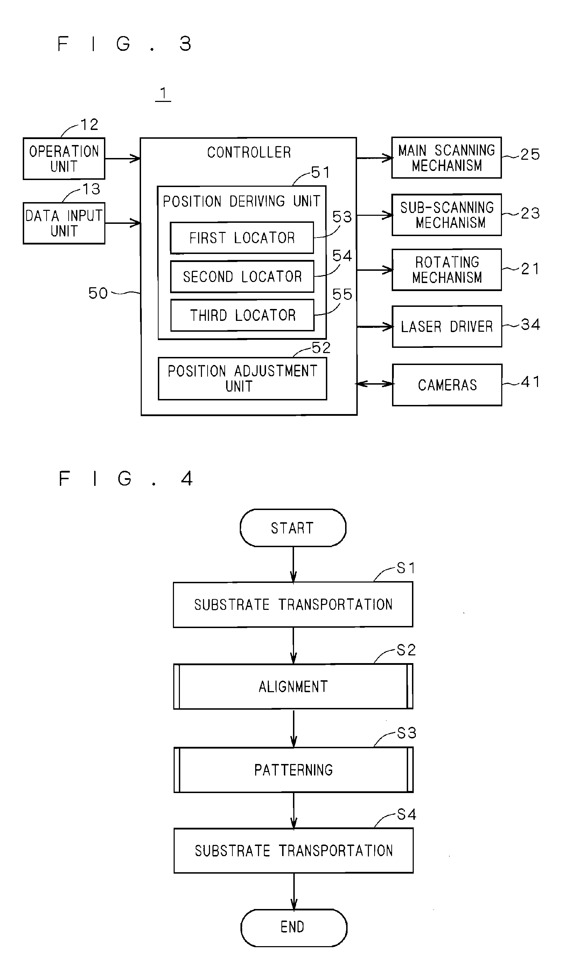

Next, a basic operation of the patterning device 1 is described. Fig. 4 is a flowchart showing the basic operation of the patterning device 1. First, the substrate 9 having previously coated thereon a photosensitive material is transported in by a transport robot or the like, and is placed on the upper surface of the stage 10. The substrate 9 is sacked through the vacuum holes formed in the upper surface of the stage 10 and held in a generally horizontal position on the upper surface of the stage 10 (step 1).

Then, alignment of the substrate 9 placed on the stage 10 is performed using the cameras 41, the position deriving unit 51, the position adjustment unit 52, and the like. Although the substrate 9 is placed in almost a predetermined ideal position on the stage 10 by a transport robot or the like, in view of the accuracy requirements for fine patterning, it is still considered to be misaligned from its ideal position. Thus, through the aforementioned alignment, the position of the substrate 9 is adjusted to the ideal position with high precision. The details of the processing for alignment will be described later (step S2).

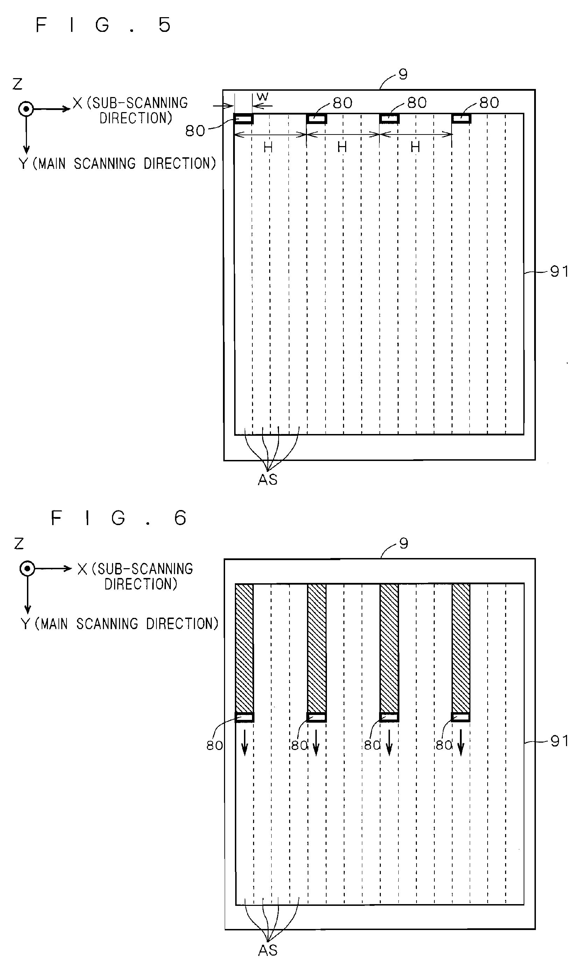

Then, regular patterns are formed on the substrate 9 whose position has been adjusted (step S3). Figs. 5 to 8 show the states of the substrate 9 during the process of patterning operation. In these figures, the area indicated by reference numeral 91 is a patterning target area to be patterned. This patterning target area 91 is defined based on patterning data previously stored in the memory in the controller 50.

Further, in these figures, the rectangular areas indicated by reference numeral 80 each are an area that can be patterned (or an area that can be exposed) by a single emission of pulse light from a single exposure head 30 (which area is hereinafter referred to as a "patterning area"). The widths of these patterning areas 80 along the sub-scanning direction is defined as a predetermined width w (in this preferred embodiment, for example 50 mm).

While, as previously described, the plurality of exposure heads 30 are arranged with the same pitch H along the sub-scanning direction, this pitch H is defined as four times the predetermined width w (in this preferred embodiment, for example 200 mm). The plurality of patterning areas 80 corresponding respectively to the plurality of exposure heads 30 are also arranged with the same pitch H (e.g., 200 mm) along the sub-scanning direction. That is, each of the exposure heads 30 scans an area of the width H on the substrate 9, which area extends to the adjacent exposure head 30 on the +X-side, in four times.

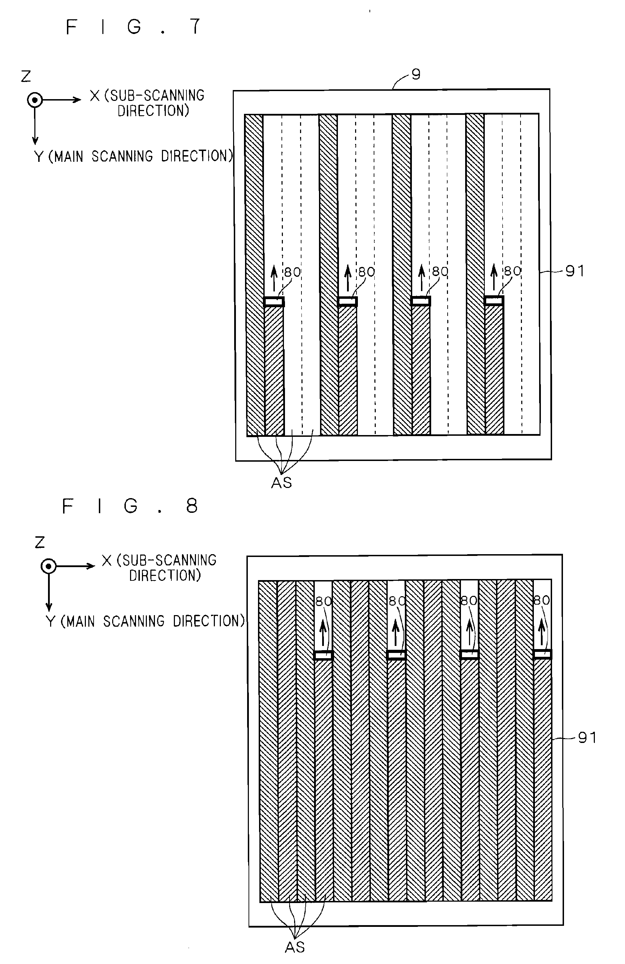

Specifically, the plurality of exposure heads 30 are first moved to their starting positions on the substrate 9 which are defined based on patterning data (Fig. 5). Then, the exposure heads 30 (i.e., the patterning areas 80) are moved toward the +Y-side in the main scanning direction with respect to the substrate 9 at a constant speed, while emitting pulse light in time cycles. Thereby, each single exposure head 30 performs an exposure scanning of a single scan area As which extends in the main scanning direction on the substrate 9 and which has the predetermined width w along the sub-scanning direction (Fig. 6). This exposure scanning results in the formation of regular patterns on the scan areas As over which the patterning areas 80 have passed. In Fig. 6, the patterned areas are indicated by hatching (the same applies to Figs. 7 and 8).

After completion of a single exposure scanning in the main scanning direction, the exposure heads 30 (i.e., the patterning areas 80) are moved by the predetermined width w toward the +X-side in the sub-scanning direction with respect to the substrate 9. Then, the exposure heads 30 (i.e., the patterning areas 80) are moved toward the -Y-side in the main scanning direction with respect to the substrate 9 at a constant speed, thereby to perform an exposure scanning of a single scan area As which is located adjacent to and on the +X side of the scan area As which has been subjected to previous exposure scanning (Fig. 7).

In a similar fashion, an exposure scanning in the main scanning direction is further repeated two times (one reciprocating motion) while moving the exposure heads 30 with respect to the substrate 9 by the predetermined width w each time in the sub-scanning direction (Fig. 8). In this way, each of the exposure heads 30 performs exposure scanning of four scan areas As obtained by dividing the area of the width H extending to the adjacent exposure head 30 on the +Y side. This results in the formation of regular patterns on the whole patterning target area 91.

The patterned substrate 9 is transported out of the upper surface of the stage 10 by a transport robot or the like (step S4 in Fig. 4). Each pattern formed on the substrate 9 is developed in the subsequent process and made into a sub-pixel representing either R, G, or B color component. Thus, the patterning target area 91 on the substrate 9 forms a single color filter.

<1-3. Alignment>

Next, the details of the alignment (step S2 in Fig. 4) of the substrate 9 performed by the patterning device 1 is described.

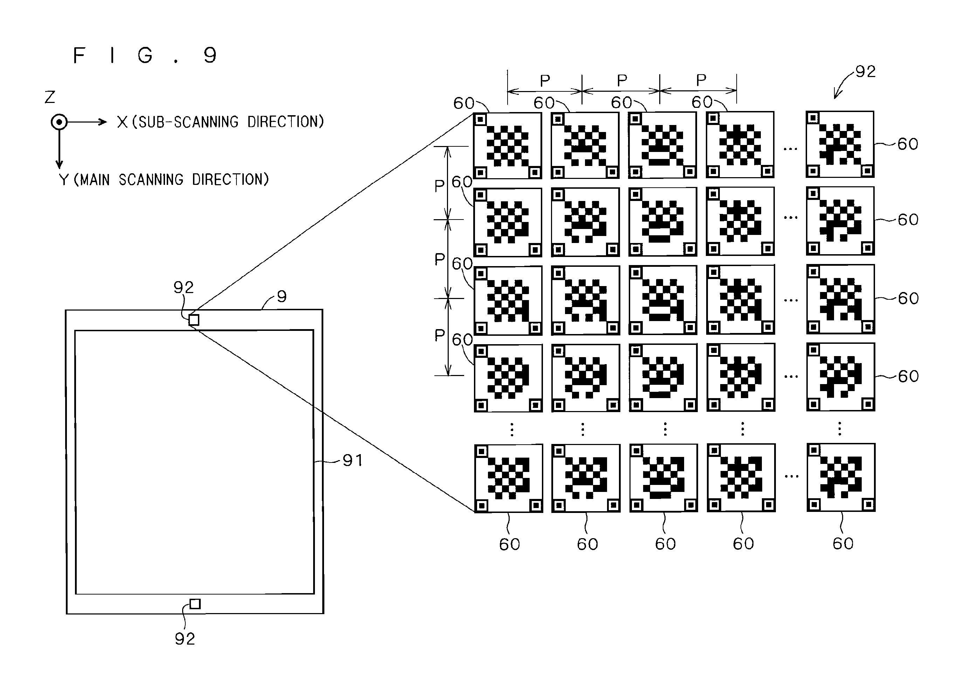

Fig. 9 shows a state of the substrate 9 to be aligned. In the following description, the aforementioned three-dimensional XYZ rectangular coordinate system is used to indicate the directions and orientations of the substrate 9 under the assumption that the substrate 9 is placed on the stage 10.

As shown in Fig. 9, the substrate 9 has alignment areas 92 for use in alignment formed in positions which are in the middle of the sides of the main body of the substrate 9 with respect to the X-axis direction (sub-scanning direction) and which are displaced toward -Y- and +Y-sides from the patterning target area 91.

As shown enlarged on the right side of Fig. 9, each of the alignment areas 92 has a group of a plurality of alignment marks 60 formed as position detection marks for use in position detection. A plurality of alignment marks 60 included in a single alignment area 92 are arranged in a two-dimensional grid. A pitch P with which the alignment marks 60 are arranged shall be constant and the same (e.g., 0.2 mm) in both the X- and Y-axis directions. Further, the same number n of alignment marks 60 are arranged in both the X- and Y-axis directions (n is a natural number in the range of, for example, 10 to 20).

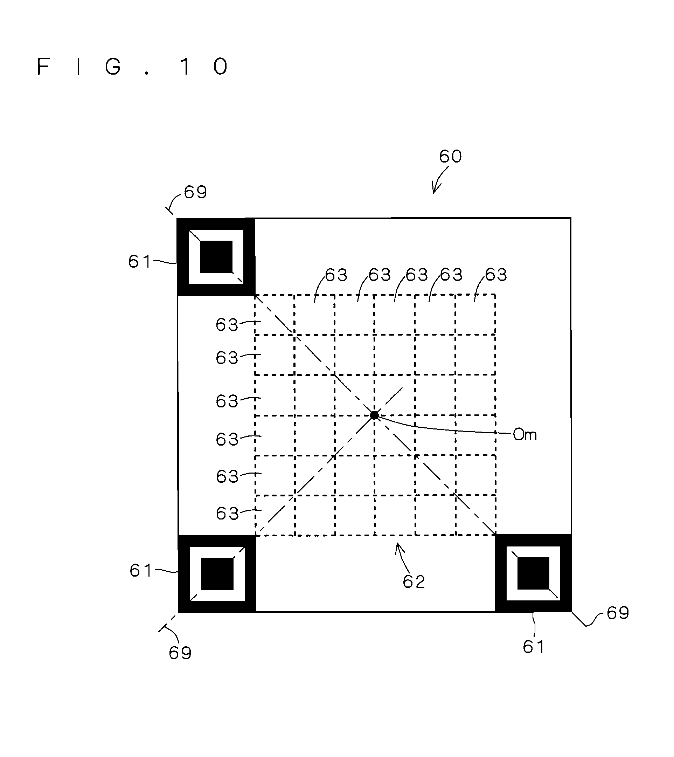

The plurality of alignment marks 60 each are an information recording code that can record information. Fig. 10 illustrates the structure of one alignment mark 60. As shown, the alignment mark 60 is configured as a two-dimensional square matrix code and has square symbols 61 of a predetermined pattern located at its three corners and a data area 62 which represents information and which is located in an area surrounded by these symbols 61.

The three symbols 61 define the outline of the alignment mark 60 and are used to recognize the whole area of the alignment mark 60. The three symbols 61 also define a position (hereinafter referred to as a "mark reference position") as a reference within the alignment mark 60. For the alignment marks 60 according to this preferred embodiment, their center positions are defined as mark reference positions Om. As shown, the mark reference position Om can be determined by finding the position of intersection of diagonal lines 69 of the three symbols 61.

The data area 62 has a number of square cells 63 arranged in a two-dimensional grid. Each of these cells 63 is either black or white, so representing one bit of information. Thus, the data area 62 can represent information of the same number of bits as the number of cells 63. That is, it can also be said that the data area 62 represents information by the presence or absence of dots which are black cells 63. For the alignment mark 60 illustrated in Fig. 10 according to this preferred embodiment, the data area 62 is composed of six cells by six cells including a total of thirty-six cells 63, so it can record 36 bits of information. As an alternative to the alignment mark 60 illustrated in Fig. 10, it is possible to increase the range of the data area 62 within the alignment mark 60 or to increase the number of cells 63 so that more information can be recorded.

Each of the alignment marks 60 records in its data area 62 the location of its own mark reference position Om relative to a predetermined reference position (hereinafter referred to as a "substrate reference position") of the substrate 9 as a main body. According to this preferred embodiment, eighteen cells, which are one half of the thirty-six cells 63 included in the data area 62, record "X-locations" which are locations relative to the substrate reference position in the X-axis direction (sub-scanning direction), while the remaining eighteen cells, or the other half, record "Y-locations" which are locations relative to the substrate reference position in the Y-axis direction (main scanning direction).

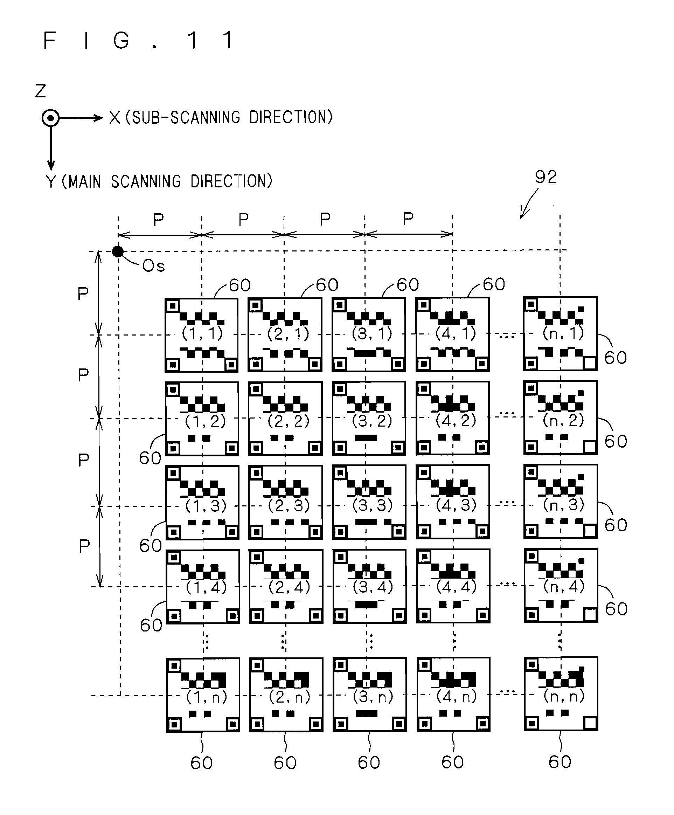

Fig. 11 illustrates the contents of information recorded in the respective alignment marks 60 included in a single alignment area 92. The contents of information recorded in each of the alignment marks 60 in the figure are in the form of "X-location, Y-location." According to this preferred embodiment, a substrate reference position Os is situated in the vicinity of the alignment mark 60 located on the -X-side end and on the -Y-side end. Each of the alignment marks 60 records a distance from this substrate reference position Os to its own mark reference position Om in the X-axis direction as the "X-location," and a distance from this substrate reference position Os to its own mark reference position Om in the Y-axis direction as the "Y-location" in a unit of pitches P (with which the alignment marks 60 are arranged).

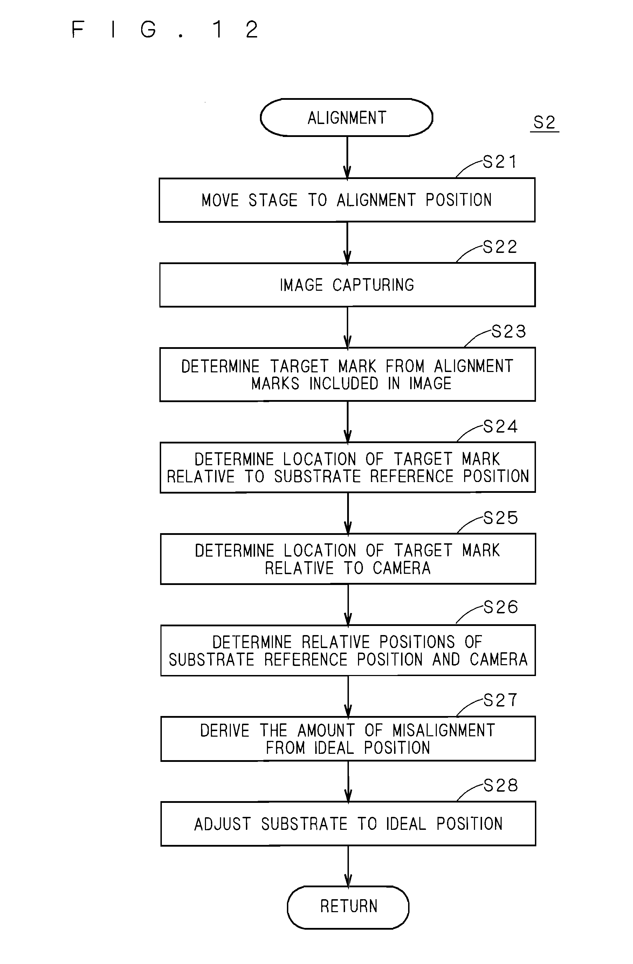

In the alignment of the substrate 9, the position of the substrate 9 is detected based on any one of such a group of the plurality of alignment marks 60. Fig. 12 is a flowchart showing the detail of processing for the alignment (step S2 in Fig. 4) of the substrate 9.

First, the stage 10 is moved to a predetermined alignment position defined by the position of the base 11 (in the state shown in Figs. 1 and 2). Thereby, two alignment areas 92 formed in the substrate 9 are located under the two cameras 41, respectively (step S21). Then, the two cameras 41 each capture a digital image of the substrate 9 (step S22). The obtained images are stored in the memory in the controller 50 so as to enable various image processing.

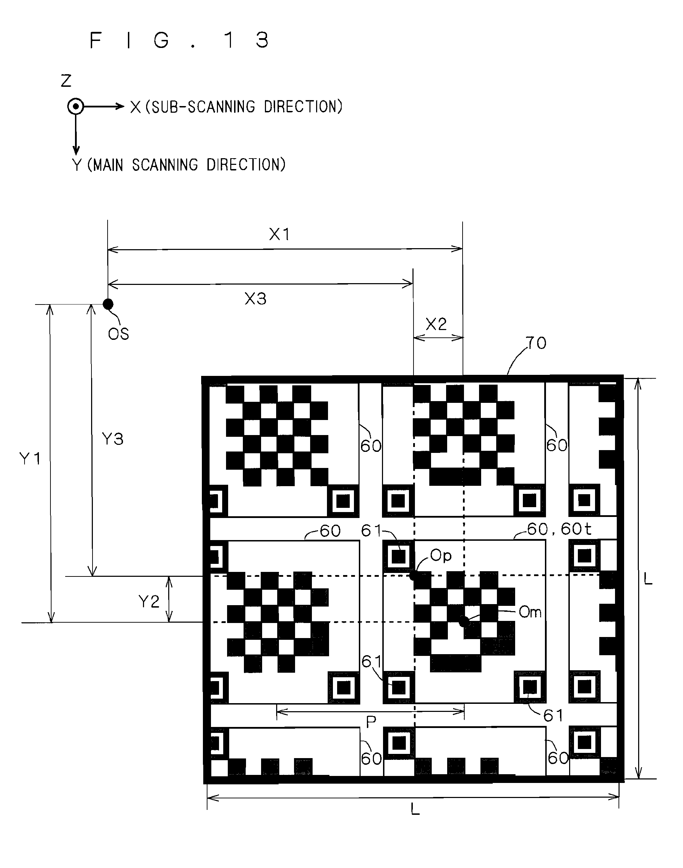

Fig. 13 shows an example of an image 70 obtained by this image capturing. In Fig. 13, subject images in the image 70 are indicated by the same reference numerals as actual subjects. Since a group of a plurality of alignment marks 60 are arranged under the cameras 41, as shown, the image 70 includes images of several alignment marks 60, at least one of which is included in a complete form. This can be achieved by setting the pitch P ($\geq$ the length of one side of an alignment mark 60 itself) with which the alignment marks 60 are arranged, to not more than one half of a length L of one side of the area of image capturing on the substrate 9. The length L of one side of the area of image capturing on the substrate 9 is defined by accuracy (image magnification) required for alignment.

Then, out of the alignment marks 60 whose images are included in the image 70, one alignment mark 60 whose whole image is completely included is determined by the position deriving unit 51 as a "target mark" 60t. If there exist a plurality of alignment marks 60 whose whole images are completely included, for example the alignment mark 60 whose image is located closest to the center position of the image 70 can be determined as the target mark 60t. Whether the whole image of the alignment mark 60 is completely included or not is determined according to whether the images of the three symbols 61 of that alignment mark 60 are completely included or not (step S23).

Then, the first locator 53 in the position deriving unit 51 reads out the contents recorded in the target mark 60t as an information recording code from the image of the target mark 60t in the image 70. This determines the "X-location" and the "Y-location" of the mark reference position Om of the target mark 60t with respect to the substrate reference position Os. That is, the first locator 53 determines the location of the mark reference position Om of the target mark 60t relative to the substrate reference position Os. The first locator 53 converts these "X-location" and "Y-location" into the unit of mm, based on the value of the pitch P previously stored in the controller 50, to obtain distances X1 and Y1 (mm), respectively (step S24).

Then, the second locator 54 determines the location of the image of the target mark 60t in the image 70. More specifically, the second locator 53 determines distances from the center position of the image 70 (which corresponds to an optic-axial position Op of the optical system of the camera 41) to the mark reference position Om of the image of the target mark 60t in both the X- and Y-axis directions in the image 70. The mark reference position Om of the image of the target mark 60t is determined by the positions of the images of the three symbols 61 of that target mark 60t.

Then, the second locator 54 converts these distances in the image 70 to actual distances in the unit of mm on the substrate 9. This determines distances X2 and Y2 (mm) from the optic-axial position Op of the camera 41 to the mark reference position Om of the target mark 60t in the X- and Y-axis directions, respectively. That is, the second locator 54 determines the location of the mark reference position Om of the target mark 60t relative to the optic-axial position Op of the camera 41. The distance X2 is positive if the mark reference position Om is located on the +X-side of the optic-axial position Op, and it is negative if the mark reference position Om is located on the -X-side of the optic-axial position Op. Similarly, the distance Y2 is positive if the mark reference position Om is located on the +Y-side of the optic-axial position Op, and it is negative if the mark reference position Om is located on the-Y-side of the optic-axial position Op (step S25).

Then, the third locator 55 determines the position of the substrate 9 based on the distances X1, Y1, X2, and Y2 determined as described above. More specifically, computations using the following equations (1) and (2) determine distances X3 and Y3 (mm) from the substrate reference position Os to the optic-axial position Op of the camera 41 in the X- and Y-axis directions, respectively.

$$X3 = X1 - X2 \qquad\qquad ...(1)$$

$$Y3 = Y1 - Y2 \qquad\qquad ...(2)$$

That is, the relative positions of the substrate reference position Os and the optic-axial position Op of the camera 41 are determined. Since, as previously described, the cameras 41 are fixed relatively to the base 11, and the stage 10 on which the substrate 9 is placed is located in an alignment position defined by the position of the base 11, the above computations substantially derive the actual position of the substrate 9 with respect to (the base 11 of) the patterning device 1 (step S26).

The distances X3 and Y3 (mm) derived as above described are further compared with their ideal distances X0 and Y0 (mm) by the position adjustment unit 52. These distances X0 and Y0, which satisfy the condition that the substrate 9 is precisely located in its ideal position, are obtained by measurement in advance and stored in the memory in the controller 50. Then, by computations using the following equations (3) and (4), the position adjustment unit 52 derives the amounts of misalignment dX and dY (mm) of the actual position of the substrate 9 from the ideal position (step S27).

$$dX = X3 - X0 \qquad \qquad ...(3)$$

$$dY = Y3 - Y0 \qquad \qquad ...(4)$$

After deriving the amounts of misalignment dX and dY in this way, in order to adjust the derived amounts of misalignment dX and dY, the position adjustment unit 52 drives the driving unit 20 to move the stage 10 and the substrate 9 held thereon. This adjusts the position of the substrate 9 to the ideal position. The amounts of misalignment dX and dY are obtained for both the two cameras 41. Thus, not only the misalignments of the substrate 9 in the X-axis direction (sub scanning direction) and in the Y-axis direction (main scanning direction) but also rotational misalignment of the substrate 9 about the Z-axis can be obtained, and those misalignments are adjusted by the main scanning mechanism 25, the sub-scanning mechanism 23, and the rotating mechanism 21 (step S28). In subsequent processing, patterning is performed on the substrate 9 whose position has been adjusted in this way, so patterns can be formed correctly in place on the substrate 9 with high precision.

As so far described, the substrate 9 to be processed by the patterning device 1 has a group of a plurality of alignment marks 60 formed within a predetermined area as the alignment area 92, each of the alignment marks 60 being an information recording code that records its own location relative to a reference position on the substrate 9. In alignment of the substrate 9, an image of such an alignment area 92 that includes a group of the plurality of alignment marks 60 is captured to obtain the image 70. Thus, even if the area of image capturing is reduced with increasing image magnification, it is possible to include at least one of the plurality of alignment marks 60 in the image 70. Then, one of the alignment marks 60 included in this image 70 is determined as the target mark 60t, and the position of the substrate 9 is derived based on the target mark 60t in the image 70. Accordingly, the position of the substrate 9 can be detected by a single image capturing operation.

Further, the location of the target mark 60t relative to the substrate reference position Os is determined by reading out the information recording code indicated by the image of the target mark 60t in the image 70, and the location of the target mark 60t relative to the camera 41 is determined based on the position of the image of the target mark 60t in the image 70. Then, based on these two relative locations, the relative positions of the substrate reference position Os and the camera 41 are determined. This technique allows precise detection of the position of the substrate 9.

<2. Second Preferred Embodiment>

Next, a second preferred embodiment is described. The following description mainly explains differences from the first preferred embodiment. According to the first preferred embodiment, each of the plurality of alignment marks 60 records its own location. On the other hand, according to the second preferred embodiment, each of the plurality of alignment marks 60 records not its own location but identification information that distinguishes itself from the other alignment marks 60, so the location of each of the alignment marks 60 can be determined based on this identification information.

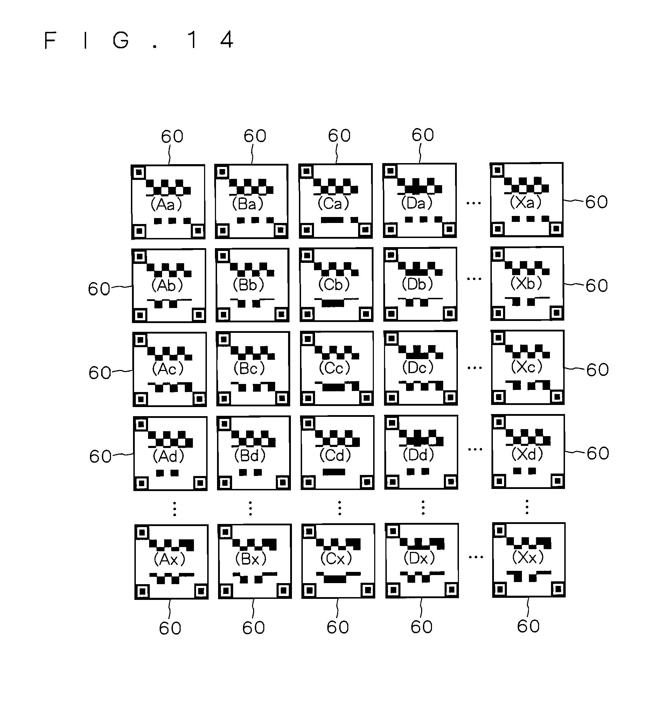

Fig. 14 illustrates the contents of information recorded in the respective alignment marks 60 included in a single alignment area 92 according to the second preferred embodiment. The contents of information included in each of the alignment marks 60 in the figure are shown within parenthesis. As shown, each of the alignment marks 60 records not its own location but two letters of the alphabet. These two letters of the alphabet are identification information for identifying the plurality of alignment marks 60 and are uniquely allocated for each of the alignment marks 60.

The memory in the controller 50 in the patterning device 1 stores a correspondence table that shows a correspondence between the identification information for each of the plurality of alignment marks 60 and the locations of the alignment marks 60 relative to the substrate reference position.

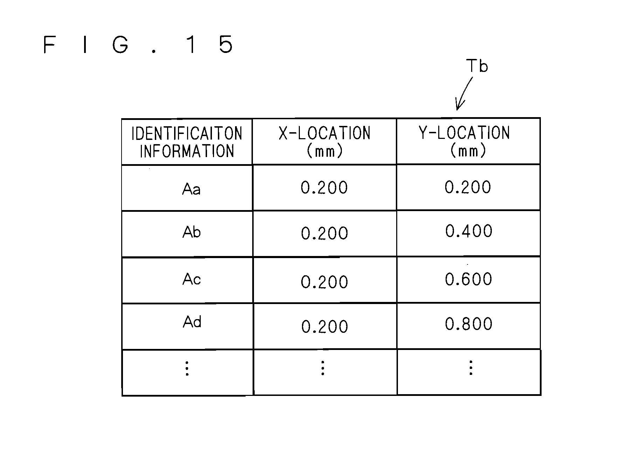

Fig. 15 shows an example of such a correspondence table Tb. As shown, the correspondence table Tb consists of a plurality of records (lines of information). In each record, identification information for one alignment mark 60 is associated with the "X-location" (mm) and "Y-location" (mm) of the mark reference position Om of that alignment mark 60 relative to the substrate reference position Os. Accordingly, referring to this correspondence table Tb and based on the identification information for an alignment mark 60, the location ("X-location" and "Y-location") of that alignment mark 60 relative to the substrate reference position Os can be obtained.

The flow of processing for the alignment of the substrate 9 according to this preferred embodiment is similar to that shown in Fig. 12, but differs only in the method of determining the location of the mark reference position Om of the target mark 60t relative to the substrate reference position Os by the first locator 53 (step S24).

In step S24 according to this preferred embodiment, the first locator 53 in the position deriving unit 51 reads out the contents recorded in the target mark 60t from the image of the target mark 60t in the image 70. By this reading, the identification information for the target mark 60t is obtained, and the correspondence table Tb is referred to based on the obtained identification information. From this, the first locator 53 determines the "X-location" and the "Y-location" which indicate the location of the mark reference position Om of the target mark 60t relative to the substrate reference position Os, to obtain the distances X1 and Y1 (mm), respectively. The processing from now on is identical to that in the first preferred embodiment.

As described above, the second preferred embodiment facilitates the determination of the locations of the alignment marks 60 by only preparing the correspondence table Tb, without the necessity for the alignment marks 60 to record their own locations.

<3. Other Preferred Embodiments>

While the preferred embodiments have been described so far, the present invention is not limited to the preferred embodiments described above, and various modifications thereto are possible. Hereinbelow, such other preferred embodiments are described. It goes without saying that the embodiments described below may be combined as appropriate.

While, in the above preferred embodiments, two alignment areas 92 are formed on a single substrate 9, the present invention is not limited thereto, and three or more alignment areas 92, or only one alignment area 92 may be formed. Further, the position where the alignment area 92 is formed is not limited to the middle of the sides of the substrate 9 along the X-axis direction but may be on the edge.

While each of the alignment marks 60 is a two-dimensional code representing information in two dimensions, it may a one-dimensional bar code. However, in order to record a large amount of information, it is desirable to employ an information recording code that represents information according to the presence or absence of dots located in a two-dimensional grid.

While, according to the first preferred embodiment, each of the alignment marks 60 records its "X-location" and "Y-location" in the unit of pitches P with which the alignment marks 60 are arranged, the "X-location" and "Y-location" may be recorded in a common unit (e.g., mm) of the SI unit system.

In the second preferred embodiment, since each alignment mark only needs to represent identification information for distinguishing itself from the other alignment marks, any other unique symbol or pattern may be employed instead of the information recording code for recording information.

While, according to the aforementioned preferred embodiments, linear motors are employed as mechanisms for driving each unit, any known driving mechanism other than linear motors may be employed. For example, a mechanism for converting the driving force of a motor into linear motion via a ball screw may be employed.

According to the aforementioned preferred embodiments, predetermined processing, i.e., patterning, is performed on the glass substrate 9 which is a subject to be processed located within a configuration area. That is, a subject to be detected whose position is to be detected is a color filter glass substrate 9. However, the present invention is not limited thereto and may be applied to any other subject to be detected. The techniques described with the aforementioned preferred embodiments are suitably applicable especially to the case where a subject to be detected is a flat plate-like subject which is large in two dimensions.

The techniques described with the aforementioned preferred embodiments are suitably applicable not only to a subject to be processed by the device (typical examples include substrates such as semiconductor substrates, printed circuit boards, and glass substrates for plasma displays, and printing paper) but also to the case where a subject to be detected is a movable part that moves inside the device.

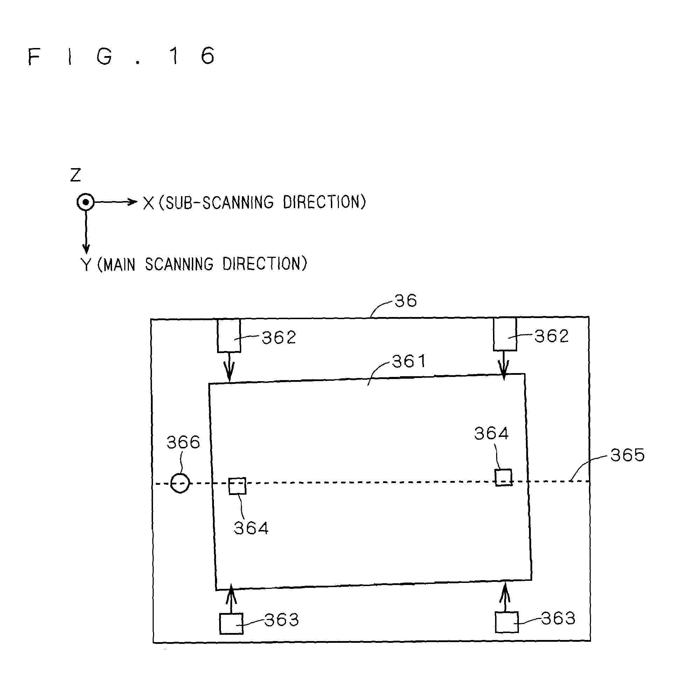

For example, the patterning device 1 according to the aforementioned preferred embodiments can employ the techniques described with the aforementioned preferred embodiments for the mask, which is a movable part located within the aperture portion 36, as a subject to be detected. Fig. 16 shows the structure of the aperture portion 36 in this case. As shown, the aperture portion 36 has provided therein a mask 361, two elastic members 362 formed of springs or the like, and two actuators 363 which are moving mechanisms for moving the mask 361. Both edges of the mask 361 on the -Y-side end along the X-axis direction are urged toward the +Y-side by the two elastic members 362. On the other hand, both edges of the mask 361 on the +Y-side end along the X-axis direction are connected to the two actuators 363. This configuration allows the mask 361 to maintain its position and allows the position of the mask 361 to be adjusted upon drive of the two actuators 363.

The mask 361 has formed therein two alignment areas 364 for use in adjustment of the position of the mask 361. These alignment areas 364, like the alignment areas 92 according to the aforementioned preferred embodiments, have formed therein a group of a plurality of alignment marks. The aperture portion 36 also has provided therein a camera 366 for capturing images of these alignment areas 364. This camera 366 is movable along the X-axis direction by a driving mechanism 365 having a predetermined guide extending in the X-axis direction.

In adjustment of the position of the mask 361, the camera 366 is moved along the X-axis direction to capture images of the two alignment areas 364. Based on the two images obtained in this way, the position of the mask 361 is detected in the same way as described in the aforementioned preferred embodiments. More specifically, the amount of misalignment of the actual position of the mask 361 from its ideal position is obtained for each of the two alignment areas 364. Although the optic-axial position of the camera 366 moves, for computations, we can use the optic-axial position of the camera 366 at the time of image capturing of each of the alignment areas 364. From this, misalignments of the mask 361 in the X- and Y-axis directions, and a rotational misalignment thereof about the Z-axis are determined. These misalignments are then adjusted by driving the actuators 363, whereby the mask 361 is located in its ideal position.

As described above, even for the case where a subject to be detected is a movable part that moves inside the device, it is possible to detect the position of the movable part with high precision, which therefore allows high-precision alignment of the movable part. Further, since the position of a subject to be detected can be detected by a single image capturing operation with a relatively high image magnification, the present invention is suitably applicable to the case where a movable part is located in such a narrow space that does not allow an increase in the area of image capturing with a camera.

While the aforementioned preferred embodiments have described on the assumption that the position detecting device is a patterning device, the techniques described with the aforementioned preferred embodiments are suitably applicable to any other device as long as it detects the position of a subject to be detected which is located within a predetermined configuration area.

While, according to the aforementioned preferred embodiments, various functions are achieved using software executed by the CPU performing computations according to a program, some of these functions may be achieved by electrical hardware circuits.

While the invention has been shown and described in detail, the foregoing description is in all aspects illustrative and not restrictive. It is therefore understood that numerous modifications and variations can be devised without departing from the scope of the invention.

**Claims**

1.    A position detecting method for detecting a position of a subject to be detected which is located within a predetermined configuration area,
said method comprising:

an image capturing step of capturing an image of said subject to be detected which has formed therein a group of a plurality of position detection marks, each of said position detection marks allowing determination of a first location which is its own location relative to a reference position on said subject to be detected; and
a position deriving step of, based on an image of one position detection mark in said image out of those of said plurality of position detection marks whose images are included in said image, determining said first location of said one position detection mark and deriving the position of said subject to be detected based on said first location.

2.    The position detecting method according to claim 1, wherein
said position deriving step includes:

a first locating step of determining said first location of said one position detection mark;
a second locating step of, based on the location of an image of said one position detection mark in said image, determining a second location which is a location of said one position detection mark relative to an image capturing device for capturing said image; and

a third locating step of determining the position of said subject to be detected, based on said first location and said second location.

3. The position detecting method according to claim 1, wherein
each of said plurality of position detection marks represents information according to the presence or absence of a plurality of dots arranged in a two-dimensional grid, and
said position deriving step determines said first location based on information represented by the image of said one position detection mark in said image.

4. The position detecting method according to claim 1, wherein
each of said plurality of position detection marks is an information recording code that records said first location thereof, and
said position deriving step determines said first location of said one position detection mark by reading said information recording code represented by the image of said one position detection mark in said image.

5. The position detecting method according to claim 1, wherein
each of said plurality of position detection marks represents identification information for distinguishing itself from the other position detection marks, and
said position deriving step determines said first location of said one position detection mark from a correspondence table showing a correspondence between said identification information for each of said plurality of position detection marks and said first location, and from said identification information represented by the image of said one position detection mark in said image.

6. The position detecting method according to claim 2, wherein
each of said plurality of position detection marks includes a symbol that defines a position to be a reference within the position detection mark, and
said second locating step determines the location of the image of said one position detection mark in said image, based on an image of said symbol in said image.

7. A position detecting device for detecting a position of a subject to be detected which is located within a predetermined configuration area,
said device comprising:

an image capturing unit for capturing an image of said subject to be detected which has formed therein a group of a plurality of position detection marks, each of said position detection marks allowing determination of a first location which is its own location relative to a reference position on said subject to be detected; and
a position deriving unit for, based on an image of one position detection mark in said image out of those of said plurality of position detection marks whose images are included in said image, determining said first location of said one position detection mark and deriving the position of said subject to be detected based on said first location.

8. The position detecting device according to claim 7, wherein
said position deriving unit includes:

a first locator for determining said first location of said one position detection mark;
a second locator for, based on the location of the image of said one position detection mark in said image, determining a second location which is a location of said one position detection mark relative to said image capturing unit; and
a third locator for determining the position of said subject to be detected, based on said first location and said second location.

9. The position detecting device according to claim 7, wherein
each of said plurality of position detection marks represents information according to the presence or absence of a plurality of dots arranged in a two-dimensional grid, and
said position deriving unit determines said first location based on information represented by the image of said one position detection mark in said image.

10. The position detecting device according to claim 7, wherein

each of said plurality of position detection marks is an information recording code that records said first position thereof, and

said position deriving unit determines said first location of said one position detection mark by reading said information recording code represented by the image of said one position detection mark in said image.

11. The position detecting device according to claim 7, wherein

each of said plurality of position detection marks represents identification information for distinguishing itself from the other position detection marks, and

said position deriving unit determines said first location of said one position detection mark from a correspondence table showing a correspondence between said identification information for each of said plurality of position detection marks and said first location, and from said identification information represented by the image of said one position detection mark in said image.

12. The position detecting device according to claim 8, wherein

each of said plurality of position detection marks includes a symbol that defines a position to be a reference within the position detection mark, and

said second locator determines the location of the image of said one position detection mark in said image, based on an image of said symbol in said image.

13. The position detecting device according to claim 7, further comprising:

a processing unit for performing predetermined processing on a subject to be processed which is located within said configuration area,

wherein said subject to be detected includes said subject to be processed.

14. The position detecting device according to claim 7, further comprising:

a movable part located within said configuration area; and

a moving mechanism for moving said movable part,

wherein said subject to be detected includes said movable part.

15. A patterning device for patterning a regular pattern on a substrate having a photosensitive material formed thereon, said patterning device comprising:

a configuration area in which said substrate is located;

the position detecting device according to claim 7 for detecting a position of said substrate located within said configuration area;

a position adjustment unit for adjusting the position of said substrate to a predetermined ideal position based on the result of detection by said position detecting device; and

a patterning unit for patterning said pattern on a substrate whose position has been adjusted by said position adjustment unit.

16. A subject to be detected whose position is to be detected by a position detecting device, said subject to be detected comprising:

a main body; and

a plurality of position detection marks which are formed in a group in said main body and each of which allows determination of its own location relative to a reference position on said main body.

F I G . 1

FIG. 2

F I G . 3

1

| OPERATION UNIT | 12 |
| DATA INPUT UNIT | 13 |

CONTROLLER

POSITION DERIVING UNIT — 51

FIRST LOCATOR — 53

SECOND LOCATOR — 54

THIRD LOCATOR — 55

50

POSITION ADJUSTMENT UNIT — 52

MAIN SCANNING MECHANISM — 25

SUB-SCANNING MECHANISM — 23

ROTATING MECHANISM — 21

LASER DRIVER — 34

CAMERAS — 41

F I G . 4

START

↓

SUBSTRATE TRANSPORTATION — S1

↓

ALIGNMENT — S2

↓

PATTERNING — S3

↓

SUBSTRATE TRANSPORTATION — S4

↓

END

F I G . 5

F I G . 6

FIG.7

Z
X (SUB-SCANNING DIRECTION)
Y (MAIN SCANNING DIRECTION)

FIG.8

Z
X (SUB-SCANNING DIRECTION)
Y (MAIN SCANNING DIRECTION)

FIG. 9

F I G . 1 0

# F I G . 1 1

EP 1 921 506 A2

F I G . 1 2

```
                    ( ALIGNMENT )                    S2

                    MOVE STAGE TO ALIGNMENT POSITION       S21

                    IMAGE CAPTURING                        S22

                    DETERMINE TARGET MARK FROM ALIGNMENT
                    MARKS INCLUDED IN IMAGE                S23

                    DETERMINE LOCATION OF TARGET MARK
                    RELATIVE TO SUBSTRATE REFERENCE POSITION  S24

                    DETERMINE LOCATION OF TARGET MARK
                    RELATIVE TO CAMERA                     S25

                    DETERMINE RELATIVE POSITIONS OF
                    SUBSTRATE REFERENCE POSITION AND CAMERA  S26

                    DERIVE THE AMOUNT OF MISALIGNMENT
                    FROM IDEAL POSITION                    S27

                    ADJUST SUBSTRATE TO IDEAL POSITION     S28

                    ( RETURN )
```

21

F I G . 1 3

# F I G . 1 4

F I G . 1 5

Tb

| IDENTIFICAITON INFORMATION | X-LOCATION (mm) | Y-LOCATION (mm) |
|---|---|---|
| Aa | 0.200 | 0.200 |
| Ab | 0.200 | 0.400 |
| Ac | 0.200 | 0.600 |
| Ad | 0.200 | 0.800 |
| ⋮ | ⋮ | ⋮ |

F I G . 1 6

Z

⊙ ——→ X (SUB-SCANNING DIRECTION)

↓
Y (MAIN SCANNING DIRECTION)